# EUROPÄISCHE PATENTSCHRIFT

(11) **EP 0 766 066 B1**
(45) Veröffentlichungstag und Bekanntmachung des Hinweises auf die Patenterteilung: **26.01.2000**
(21) Anmeldenummer: 96111581.3
(22) Anmeldetag: 18.07.1996
(51) Int. Cl.: G01D 5/14, G01D 3/028

(54) **Magnetische Positionsmesseinrichtung sowie Verfahren zu deren Betrieb**
Magnetic position measuring device as well as method for operating the same
Dispositif magnétique pour déterminer la position ainsi que la procédure de son opération

(30) Priorität: 30.09.1995 DE 19536661
(43) Veröffentlichungstag der Anmeldung: 02.04.1997
(73) Patentinhaber: Dr. Johannes Heidenhain GmbH, 83292 Traunreut (DE)
(72) Erfinder: Spies, Alfons, Dipl.-Ing., 83358 Seebruck (DE)

(56) Entgegenhaltungen:
- EP-A- 0 093 232
- EP-A- 0 548 391
- WO-A-94/05975
- GB-A- 2 056 692

## Beschreibung

Die vorliegende Erfindung betrifft eine magnetische Positionsmeßeinrichtung nach dem Oberbegriff des Anspruches 1. Gegenstand der vorliegenden Erfindung ist ferner ein Verfahren zum Betrieb einer magnetischen Positionsmeßeinrichtung gemäß dem Oberbegriff des Anspruches 8.

Neben den bekannten Positionsmeßeinrichtungen auf optischem Prinzip gewinnen zusehens Positionsmeßeinrichtungen basierend auf magnetischen Meßprinzipien an Bedeutung. Eine gattungsgemäße magnetische Positionsmeßeinrichtung ist hierbei etwa aus der GB 2 056 692 A bekannt. Insbesondere die geringe Verschmutzungsanfälligkeit derartiger Positionsmeßeinrichtungen macht den Einsatz etwa im Werkzeugmaschinenbereich attraktiv. Den bekannten magnetischen Positionsmeßeinrichtungen ist hierbei jeweils gemeinsam, daß eine magnetische Meßteilung mit Hilfe einer Abtasteinheit, die geeignete Magnet-Sensoren enthält, abgetastet wird. Hierbei werden Ausgangssignale der Magnet-Sensoren generiert, die wiederum bekannten Auswerte- und Interpolationseinrichtungen zugeführt werden. Die eingesetzten magnetischen Meßteilungen können analog zu optischen Meßsystemen als Teilungen mit fester Teilungsperiode ausgeführt sein oder ein definiertes Codemuster aufweisen.
Eine weitere Positionsmeßeinrichtung, bei der als magnetfeldempfindliche Sensorelemente innerhalb der Abtasteinheit Hall-Elemente verwendet werden, ist z.B. aus der EP 093 232 bekannt. Ein grundsätzlich immer vorhandenes Problem stellt bei der Verwendung von Hall-Elementen als Sensoren die Nullspannungsdrift bzw. Offset-Schwankungen der Hall-Elemente dar. Derartige Offset-Schwankungen bei Hall-Elementen resultieren aufgrund von Material-Inhomogenitäten, mechanischer Belastung der Hall-Elemente sowie nicht exakt eingehaltenen Herstellungstoleranzen. Die vorhandenen Offset-Schwankungen verursachen damit unerwünschte Fehler bei der Verwendung von Hall-Elementen als magnetfeldempfindliche Sensoren in magnetischen Positionsmeßeinrichtungen.

Zur Kompensation von Offset-Schwankungen in Hall-Elementen ist nunmehr aus der EP 0 548 391 A1 bekannt, in einem Hall-Element den Halldetektor-Versorgungsstrom und die Hallspannungsabgriffe mit Hilfe einer geeigneten Einrichtung orthogonal umzuschalten. Die Druckschrift gibt jedoch keinerlei Hinweise, wie über diese Maßnahme etwa eine geeignete magnetische Positionsmeßeinrichtung aufzubauen ist.

Aufgabe der vorliegenden Erfindung ist es daher, eine magnetische Positionsmeßeinrichtung mit Hall-Elementen als magnetfeldempfindlichen Sensoren zu schaffen, bei denen Offset-Schwankungen eliminiert werden.

Diese Aufgabe wird für eine gattungsgemäße Vorrichtung durch die im kennzeichnenden Teil des Anspruches 1 angegebenen Maßnahmen gelöst.

Vorteilhafte Ausgestaltungen der erfindungsgemäßen Vorrichtung ergeben sich aus den Merkmalen der abhängigen Ansprüche.

Ein Verfahren zum Betrieb einer magnetischen Positionsmeßeinrichtung, bei dem die oben genannten Probleme minimiert werden, ist Gegenstand des Anspruches 8.
Weiterbildungen und Ausgestaltungen des erfindungsgemäßen Verfahrens ergeben sich aus den von Anspruch 8 abhängigen Ansprüchen.

Das erfindungsgemäße Verfahren bzw. die erfindungsgemäße magnetische Positionsmeßeinrichtung gewährleistet nunmehr die gewünschte Eliminierung der störenden und signalverfälschenden Offset-Schwankungen. Dies wird durch den Einsatz von Hall-Elementen erreicht, welche nach dem sogenannten "Spinning-Current-Prinzip" betrieben werden, wie es beispielsweise in der DE 43 02 342 oder in der Veröffentlichung "A low-offset spinning-current Hallplate" von P.J.A. Munter in "Sensors and Actuators A (Physical)", März 1990, Vol. A22, No. 1-3, S.743-746 vorgeschlagen wurde.

Je nach gewünschter Meßgenauigkeit ist es dabei jederzeit möglich, auch mehr als die mindestens erforderlichen zwei Hall-Elemente innerhalb einer magnetischen Positionsmeßeinrichtung in bestimmten Relativanordnungen einzusetzen.

In Verbindung mit den erfindungsgemäß betriebenen Hall-Elementen lassen sich desweiteren bekannte Auswerte- und Interpolationseinheiten zur eigentlichen Positionsbestimmung einsetzen, wie sie z.B. in Verbindung mit konventionellen Resolvern bekannt sind.

Ebenso ergeben sich eine Reihe von Möglichkeiten zur Kombination der Hall-Elemente mit den erforderlichen Schalt- und Synchronisationseinheiten. Es ist somit eine flexible Anpassung der erfindungsgemäßen Vorrichtung an die Meß-Anforderungen in Abhängigkeit vom gewünschten Schaltungsaufwand bzw. der gewünschten Meßgenauigkeit möglich.

Als vorteilhaft erweist sich ferner eine Integration sämtlicher Sensorkomponenten auf einem einzigen Sensorchip, womit ein kompakter Sensor für eine magnetische Positionsmeßeinrichtung zur Verfügung steht.

Weitere Vorteile sowie Einzelheiten der erfindungsgemäßen Vorrichtung bzw. des erfindungsgemäßen Verfahrens ergeben sich aus der nachfolgenden Beschreibung von Ausführungsbeispielen anhand der beiliegenden Figuren.

Dabei zeigt
- Figur 1: eine schematisierte Darstellung einer magnetischen Positionsmeßeinrichtung gemäß der vorliegenden Erfindung;
- Figur 2: eine Prinzipskizze zur Funktionsweise der verwendeten Hall-Elemente;
- Figur 3A - 3D: je eine unterschiedliche Schaltungsphase der verwendeten Hall-Elemente aus Fig. 2;
- Figur 4: eine weitere mögliche Ausführungsform der einzusetzenden Hall-Elemente;
- Figur 5: ein Blockschaltbild einer magnetischen Positionsmeßeinrichtung mit 2 verwendeten Hall-Elementen;
- Figur 6A und 6B: je einen Teil eines Blockschaltbildes einer weiteren Ausführungsform der erfindungsgemäßen Positionsmeßeinrichtung mit insgesamt 4 eingesetzten Hall-Elementen.

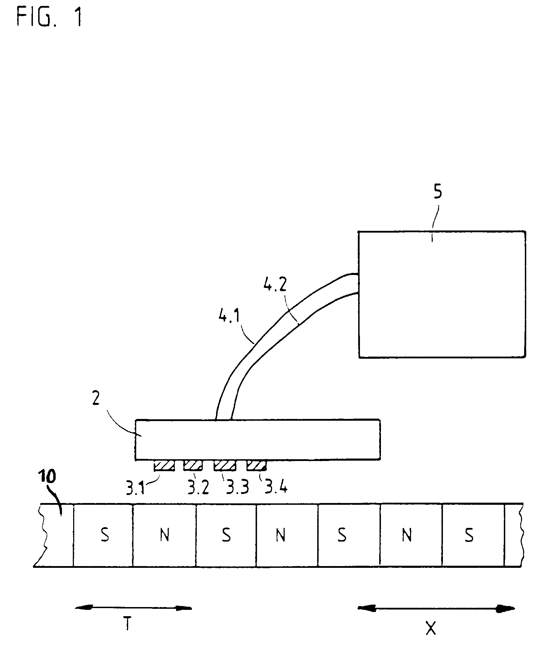

In Figur 1 ist in schematisierter Form eine magnetische Positionsmeßeinrichtung gemäß der vorliegenden Erfindung dargestellt. Die magnetische Positionsmeßeinrichtung umfaßt zum einen die magnetische Meßteilung (10), auf der ein bestimmtes Magnetisierungsmuster aufgebracht ist. Zum anderen ist eine Abtasteinheit (2) vorgesehen, welche in der dargestellten Ausführungsform vier Hall-Elemente (3.1, 3.2, 3.3, 3.4) als magnetfeld-empfindliche Sensoren umfaßt, deren Funktionsweise im Detail anhand der folgenden Figuren noch näher erläutert wird. Mit den Hall-Elementen (3.1, 3.2, 3.3, 3.4) bzw. der Abtasteinheit (2) ist über elektrische Verbindungsleitungen (4.1, 4.2) eine nachgeordnete Interpolations- und Auswerteeinheit (5) verbunden, die die Ausgangssignale der Abtasteinheit (2) in Zählimpulse umwandelt.

Die magnetische Meßteilung (10) ist im dargestellten Ausführungsbeispiel der Figur 1 in einseitig mehrpoliger Form magnetisiert, wobei alternierend Nord- und Südpole (N, S) aneinander stoßen. Als magnetische Teilungsperiode T sei hierbei diejenige Länge verstanden, die sich in Meßrichtung X aus der Entfernung zwischen zwei Nord- oder Südpolen ergibt. Alternativ zur dargestellten Magnetisierung können auch andere Magnetisierungsmuster vorgesehen werden, wie etwa eine sogenannte axial einseitige Magnetisierung oder aber auch ein unregelmäßiges Code-Magnetisierungsmuster. Ferner kann die jeweils abgetastete magnetische Meßteilung auch prinzipiell über eine Elektromagneten-Anordnung etc. realisiert werden.

Darüber hinaus ist nicht nur eine Längenmeßvorrichtung erfindungsgemäß realisierbar, sondern bei einer radialen Ausbildung der magnetischen Meßteilung auch eine entsprechende Winkelmeßeinrichtung.

Die magnetische Meßteilung (10) ist in einer möglichen Anwendung mit dem Bett einer - nicht dargestellten - Werkzeugmaschine verbunden, während die Abtasteinheit (2) mit den Hall-Elementen (3.1, 3.2, 3.3, 3.4) an einem linear verfahrbaren Schlittenteil der Maschine angeordnet ist, welches in Figur 1 ebenfalls nicht dargestellt ist.

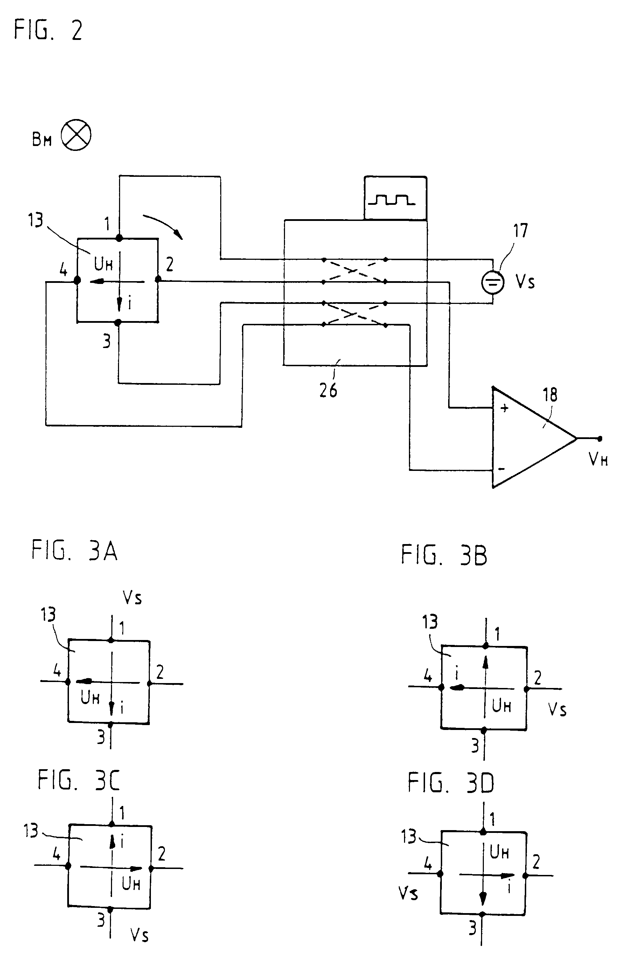

Eine Erläuterung der prinzipiellen Funktionsweise der erfindungsgemäß eingesetzten Hall-Elemente erfolgt nunmehr anhand der Figur 2. Das dargestellte Hall-Element (13) in quadratischer Form weist je zwei Versorgungsspannungs-Anschlüsse (1, 3) sowie um 90° hierzu versetzt zwei Meßspannungs-Anschlüsse (2, 4) auf. Das zu detektierende Meßteilungs-Magnetfeld B_{M} bzw. die entsprechenden Magnetfeld-Komponenten sind relativ zum Hall-Element (13) senkrecht orientiert. Beim Anlegen einer Versorgungsspannung V_{S} an die beiden Anschlüsse 1 und 3 kann in bekannter Art und Weise über die beiden Meßspannungs-Anschlüsse 2 und 4 bei einem vorhandenem Magnetfeld B_{M} eine Hall-Spannung U_{M} abgegriffen werden, die ein Maß für das externe Magnetfeld B_{M} der magnetischen Meßteilung darstellt.

Erfindungsgemäß wird nunmehr vorgesehen, innerhalb einer magnetischen Positionsmeßeinrichtung mindestens zwei Hall-Elemente zu verwenden, die nach dem sogenannten "Spinning-Current-Prinzip" betrieben werden. Hierzu ist mindestens eine Schalteinheit (26) vorgesehen, die in zeitlich periodischer Folge die Versorgungsspannungs- (1, 3) und Meßspannungs-Anschlüsse (2, 4) der Hall-Elemente (13) miteinander vertauscht bzw. durchschaltet. Dies geschieht vorzugsweise mit einer relativ hohen Frequenz, die zwischen 10kHz - 200kHz liegen kann. In Figur 2 ist ein derartiges Vertauschen der Versorgungs- (1, 3) und Meßspannungs-Anschlüsse (2, 4) innerhalb der Schalteinheit (26) schematisiert für ein einzelnes Hall-Element (13) in zwei Schaltungsphasen dargestellt.

Die Figuren 3A - 3D zeigen die vier möglichen Schaltungsphasen für das Hall-Element (13) aus Figur 2. Während in Figur 3A die von der Versorgungs-Spannungsquelle (17) gelieferte Versorgungsspannung V_{S} an den beiden Anschlüssen 1 und 3 anliegt, was über den Versorgungsstrom i verdeutlicht werden soll, wird die Meßspannung U_{M} an den beiden Anschlüssen 2 und 4 abgegriffen. In der darauf folgenden Meß- bzw. Schaltungsphase werden die Anschlüsse 1, 3 und 2, 4 miteinander vertauscht, das heißt die Versorgungsspannung V_{S} liegt nunmehr an den beiden Anschlüssen 2 und 4 in der gezeigten Richtung an, während die Meßspannung U_{M} an den Anschlüssen 1 und 3 abgegriffen wird. Analog hierzu wird bei der in Figur 3C dargestellten Schaltungsphase die Versorgungsspannung V_{S} an die beiden Anschlüsse 3 und 1 angelegt, numehr jedoch in umgekehrter Richtung wie in der Schaltungsphase gemäß Figur 3A. Die Meßspannung U_{M} wird wiederum an den beiden Anschlüssen 4 und 2 abgegriffen, jedoch ebenfalls in umgekehrter Richtung wie in Figur 3A. In der in Figur 3D schließlich dargestellten, vierten Schaltungsphase liegt die Versorgungsspannung V_{S} an den beiden Anschlüssen 4 und 2, die Meßspannung U_{M} wird über die Anschlüsse 1 und 3 erfaßt; Versorgungs- und Meßspannung sind hierbei entgegengesetzt zur Schaltungsphase aus Figur 3B orientiert.
Von Schaltungsphase zu Schaltungsphase werden bei dieser Anordnung somit die Versorgungs- und Meßspannungs-Anschlüsse des eingesetzten Hall-Elementes (13) im Uhrzeigersinn gleichsinnig um jeweils 90° weitergeschaltet.

Ausgangsseitig gelangen die resultierenden Meßsignale auf die Eingänge eines Differenzverstärkers (18), wo die Signal-Weiterverarbeitung erfolgt. Am Ausgang des Differenzverstärkers (18) liegt in der dargestellten Betriebsart das offsetfreie magnetfeldproportionale Signal V_{H} an. Dieses Signal ist von einem Offset-Wechselspannungsanteil überlagert, der sich jedoch mittels bekannter Filter einfach vom interessierenden Signalanteil trennen läßt. Bei der Relativbewegung zwischen magnetischer Meßteilung und Hall-Element (13) ergibt sich somit ein entsprechend amplitudenmoduliertes Meßsignal V_{H} am Differenzverstärker-Ausgang, welches in bekannter Art und Weise weiterverarbeitet werden kann.

Durch das periodische Durchschalten der Versorgungs- und Meßspannungs-Anschlüsse über 360° und geeigneter Summen- oder Differenz-Bildung kann somit der Nullspannungsanteil am Magnetfeld-Signal eliminiert werden.

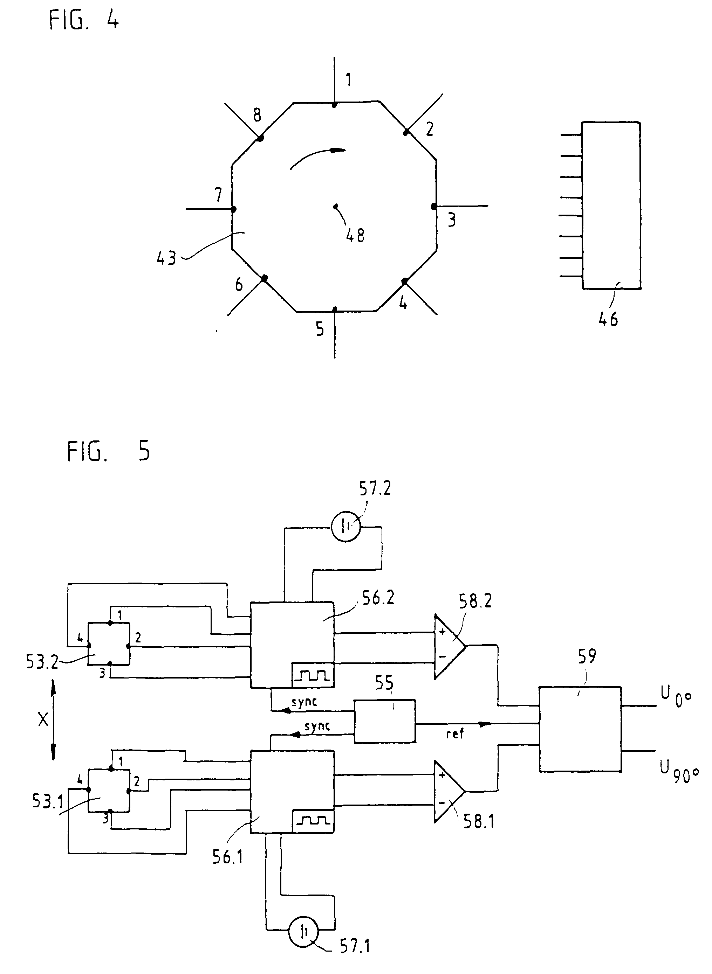

Innerhalb einer magnetischen Positionsmeßeinrichtung sind erfindungsgemäß mindestens zwei derartig betriebene Hall-Elemente erforderlich, um die üblicherweise gewünschte Richtungs-Diskriminierung zu ermöglichen. Eine entsprechende schematische Darstellung einer möglichen Ausführungsform der erfindungsgemäßen magnetischen Positionsmeßeinrichtung findet sich in Figur 5.

Vorab sei jedoch noch auf eine weitere mögliche Ausführungsform der derart betriebenen Hall-Elemente gemäß Figur 4 hingewiesen. Das dort dargestellte Hall-Element (43) weist eine achteckige Form auf, wobei vier Paare von sich gegenüberliegenden Versorgungsspannungs- und Meßspannungs-Anschlüssen (1...8) vorgesehen sind. Die verschiedenen Anschlüsse (1...8) sind hierbei zyklisch um den Mittelpunkt (48) des Hall-Elementes (43) verteilt.
In einer derartigen Ausführungsform der Hall-Elemente werden die Versorgungs- und Meßspannungen in zeitlich periodischer Folge von Schaltphase zu Schaltphase jeweils lediglich um 45° zyklisch weitergeschaltet, wodurch eine Genauigkeitssteigerung bei der Ermittlung der driftfreien Magnetfeld-Signale erreicht werden kann. Verallgemeinert bedeutet dies, daß im Fall von n vorgesehenen Anschlüssen diese jeweils in Winkelabständen von 360°/n zueinander angeordnet sind und entsprechend ein periodisches Durchschalten in Schritten von 360°/n erfolgt.
Neben dem Hall-Element (43) ist in Figur 4 in ebenfalls schematisierter Form eine Multiplex-Einheit (46) dargestellt, welche das Weiterschalten bzw. Vertauschen der Versorgungsspannungs- und Meßspannungs-Anschlüsse (1...8) in zeitlich periodischer Folge gewährleistet, d.h. als Schalteinheit wie oben beschrieben fungiert.

Neben der gleichsinnigen Rotation von Versorgungsspannung und Meßspannung kann desweiteren durch geeignetes Umschalten auch ein gegensinniges Durchschalten der verschiedenen Anschlüsse realisiert werden. In diesem Fall resultiert ein dem zu messenden Magnetfeld proportionales Wechselspannungssignal sowie ein Nullspannungs-Gleichsignal. Die Weiterverarbeitung des magnetfeld-proportionalen Wechselspannungssignals kann beispielsweise über die bekannte Amplitudenauswertung trägerfrequenter Signale erfolgen, wie sie etwa im Zusammenhang mit sogenannten Resolvern geläufig ist. Es sei hierzu etwa auf das Kapitel "Abtastung mit Trägerfrequenz" in "Digitale Längen- und Winkelmeßtechnik" von A. Ernst, verlag moderne industrie AG, Landsberg, 3.Auflage 19993, S. 27-28 verwiesen.

Es ist desweiteren möglich, verschiedenste Kombinationen von derart betriebenen Hall-Elementen innerhalb einer magnetischen Positionsmeßeinrichtung einzusetzen.

Wie bereits vorab erwähnt zeigt Figur 5 eine Blockschaltbild-Darstellung einer magnetischen Positionsmeßeinrichtung mit zwei Hall-Elementen (53.1, 53.2) in quadratischer Form. Eine Verschiebung der beiden Hall-Elemente (53.1, 53.2) relativ zur - nicht dargestellten - Meßteilung erfolgt in der Zeichenebene in Richtung des Pfeiles. Die beiden Hall-Elemente (53.1, 53.2) sind ferner um ein Viertel der Teilungsperiode der magnetischen Meßteilung versetzt zueinander innerhalb der Abtasteinheit angeordnet, so daß eine Phasenverschiebung der jeweiligen Ausgangssignale von 90° resultiert.

Jedem der beiden Hall-Elemente (53.1, 53.2) ist im dargestellten Ausführungsbeispiel eine Schalteinheit (56.1, 56.2) zugeordnet, die in einer bestimmten Taktfrequenz die Versorgungsspannungs- und Meßspannungs-Anschlüsse periodisch vertauscht bzw. über 360° in 90°-Schritten durchschaltet. Das periodische Vertauschen bzw. Durchschalten soll wie in Figur 3 durch das den Schalteinheiten (56.1, 56.2) jeweils zugeordnete Rechtecksignal schematisiert angedeutet werden. Die Versorgungs- und Meßspannungs-Anschlüsse werden wiederum gleichsinnig durchgeschaltet.

Desweiteren ist für jedes der beiden Hall-Elemente (53.1, 53.2) eine Versorgungs-Spannungsquelle (57.1, 57.2) vorgesehen, die jeweils ebenfalls mit der entsprechenden Schalteinheit (56.1, 56.2) verbunden ist.
Alternativ hierzu kann auch lediglich eine einzige Schalteinheit bzw. eine einzige Versorgungs-Spannungsquelle vorgesehen werden, die in einem geeigneten Multiplex-Betrieb arbeitet.

Die resultierenden Signale werden wiederum geeigneten Differenz-Verstärkern (58.1, 58.2) zugeführt, der Offset-Gleichanteil abgetrennt und auf eine Interpolations-Einheit (59) durchgeschaltet, die wiederum die beiden zur weiteren Auswertung erforderlichen 0°- und 90°-Zählsignale (U_{0°}, U_{90°}) liefert. Die vorgesehene Interpolationseinheit (59) verarbeitet die bei einer Relativ-Bewegung von Abtasteinheit und magnetischer Meßteilung resultierenden amplitudenmodulierten Signale wieder in bekannter Art und Weise.

Daneben ist eine Synchronisations-Einheit (55) innerhalb der erfindungsgemäßen magnetischen Positionsmeßeinrichtung vorgesehen, die dafür sorgt, daß das zyklische Durchschalten der Versorgungs- und Meßspannungen in den beiden Hall-Elementen (53.1, 53.2) synchronisiert miteinander erfolgt. Hierzu werden geeignete Synchronisationsssignale (sync) an die Schalteinheiten (56.1, 56.2) weitergegeben. Ferner taktet die Synchronisationseinheit (55) über ein weiteres Referenz-Signal (ref) auch die Interpolations-Einheit (59). Die Synchronisationseinheit (55) umfaßt hierzu eine geeignete Oszillatoreinheit, die die entsprechenden periodischen Taktsignale erzeugt.

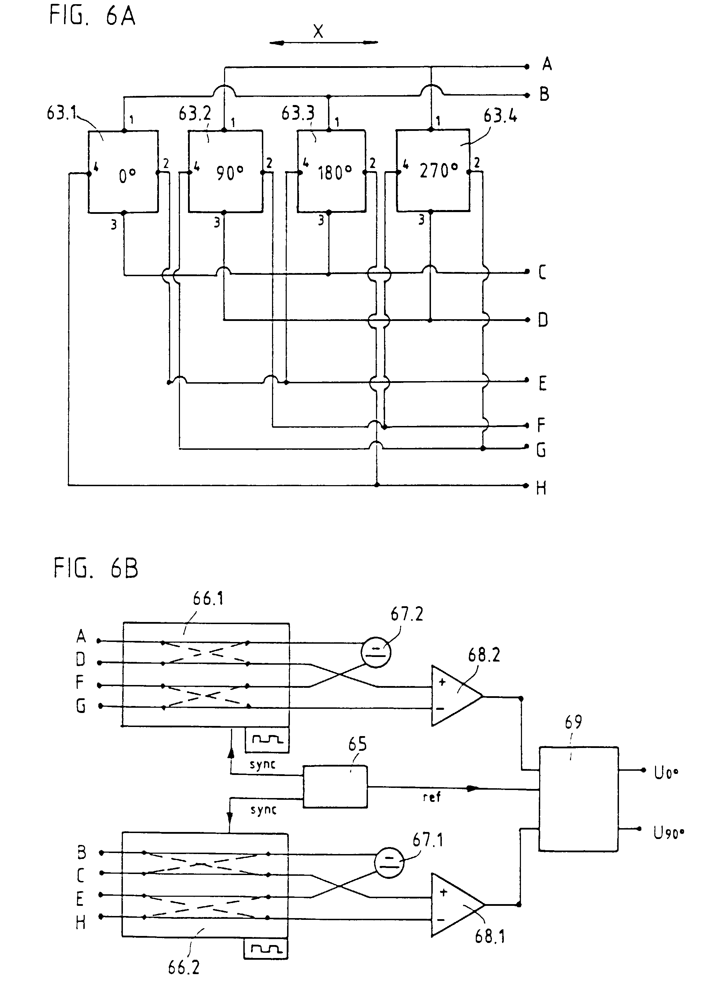

Eine weitere Ausführungsform der erfindungsgemäßen magnetischen Positionsmeßeinrichtung ist schematisisiert in den beiden Figuren 6a und 6b dargestellt. Hierbei sind nunmehr vier Hall-Elemente (63.1, 63.2, 63.3, 63.4) innerhalb der Abtasteinheit vorgesehen, die synchronisiert miteinander wie vorab beschrieben betrieben werden. Die vier Hall-Elemente (63.1, 63.2, 63.3, 63.4) sind jeweils im Abstand einer Viertel-Teilungsperiode der magnetischen Meßteilung zueinander angeordnet und liefern bei der Relativbewegung von Meßteilung und Abtasteinheit in Meßrichtung X vier Ausgangssignale, die jeweils um 90° zueinander phasenversetzt sind. Es ist somit eine nochmals weitergehende Verbesserung der Auflösung bzw. eine optimierte Signalgewinnung gewährleistet.

Die dargestellte Ausführungsform umfaßt zwei Schalteinheiten (66.1, 66.2), zwei Versorgungs-Spannungsquellen (67.1, 67.2), zwei Differenzverstärker (68.1, 68.2) sowie eine Interpolations- (69) und eine Synchronisationseinheit (65), die prinzipiell wie vorab beschrieben betrieben werden. Die Hall-Element-Ausgänge (1, 2, 3, 4) sind in der dargestellten Art und Weise miteinander verschaltetet und haben insgesamt acht Ausgänge (A, ...H), welche in der dargestellten Form auf die Eingänge der Schalteinheiten (66.1, 66.2) gelegt und in entsprechender Weise periodisch durchgeschaltet werden.
Innerhalb der Ausführungsform gemäß Figur 6A und 6B sind demzufolge die gleichen Ausgänge von je zwei Hall-Elementen (63.1, 63.2, 63.3, 63.4) gruppenweise zusammengefaßt verschaltet worden, so daß für jede der beiden Gruppen lediglich eine gemeinsame Schalteinheit (66.1, 66.2) erforderlich ist. Die erste Gruppe umfaßt demzufolge das von links aus erste und dritte Hall-Element (63.1, 63.3), während in der zweiten Gruppe das zweite und vierte Hall-Element (63.2, 63.4) zusammengefaßt wird.

In einer weiteren möglichen Ausführungsform ist vorgesehen, die erfindungsgemäß betriebenen Hall-Elemente sowie die nachgeordneten Verarbeitungs-Einheiten in integrierter Form auf einem Trägersubstrat bzw. Chip anzuordnen und dergestalt eine kompakte Ausführung der Abtasteinheit sicherzustellen. Hierbei werden die verschiedenen Komponenten wie Sensoren und Ansteuer- und Auswerte-Elektronik in CMOS-Technologie gefertigt.

## Patentansprüche

1. Magnetische Positionsmeßeinrichtung zur Bestimmung der Relativlage zweier zueinander beweglicher Objekte, bestehend aus einer magnetischen Meßteilung (10) und mindestens zwei Hall-Elementen (3.1, 3.2, 3.3, 3.4; 13; 43; 53.1, 53.2; 63.1, 63.2, 63.3, 63.4), mit denen die Meßteilung (10) zur Erzeugung mindestens zweier, phasenverschobener positionsabhängiger Ausgangssignale abgetastet wird, wobei die Hall-Elemente (3.1, 3.2, 3.3, 3.4; 13; 43; 53.1, 53.2; 63.1, 63.2, 63.3, 63.4) jeweils mindestens einen Versorgungsspannungs- und einen Meßspannungs-Anschluß (1, 2, 3, 4) aufweisen, gekennzeichnet durch
- mindestens eine Schalteinheit (26; 46; 56.1, 56.2; 66.1, 66.2), die die Versorgungsspannungs- und Meßspannungs-Anschlüsse (1, 2, 3, 4) jedes Hall-Elements (3.1, 3.2, 3.3, 3.4; 13; 43; 53.1, 53.2; 63.1, 63.2, 63.3, 63.4) periodisch miteinander vertauscht und
- mindestens eine Synchronisationseinheit (55; 65), die das periodische Vertauschen der Versorgungsspannungs- und Meßspannungs-Anschlüsse (1, 2, 3, 4) der verschiedenen Hall-Elemente (3.1, 3.2, 3.3, 3.4; 13; 43; 53.1, 53.2; 63.1, 63.2, 63.3, 63.4) miteinander synchronisiert und hierzu Synchronisationssignale (sync) an die Schalteinheiten (26; 46; 56.1, 56.2; 66.1, 66.2) weitergibt.

2. Magnetische Positionsmeßeinrichtung nach Anspruch 1, dadurch gekennzeichnet, daß mehrere Hall-Elemente (63.1, 63.2, 63.3, 63.4) vorgesehen sind, deren Versorungs- und Meßspannungs-Anschlüsse (1, 2, 3, 4) jeweils gruppenweise miteinander verbunden sind und für jede Gruppe eine gemeinsame Schalteinheit (66.1, 66.2) vorgesehen ist.

3. Magnetische Positionsmeßeinrichtung nach Anspruch 1, dadurch gekennzeichnet, daß die verwendeten Hall-Elemente (3.1, 3.2, 3.3, 3.4; 13; 43; 53.1, 53.2; 63.1, 63.2, 63.3, 63.4) jeweils n zyklisch um den Hall-Element-Mittelpunkt (48) angeordnete Versorgungsspannungs- und/oder Meßspannungs-Anschlüsse (1..4; 1..8) aufweisen, die in Winkelabständen von 360°/n voneinander angeordnet sind.

4. Magnetische Positionsmeßeinrichtung nach Anspruch 1, dadurch gekennzeichnet, daß eine magnetische Meßteilung (10) mit einer festen Teilungsperiode (T) vorgesehen ist und mindestens zwei Hall-Elemente (3.1, 3.2, 3.3, 3.4; 13; 43; 53.1, 53.2; 63.1, 63.2, 63.3, 63.4) um den Abstand einer Viertel-Teilungsperiode (T) der magnetischen Meßteilung (10) voneinander versetzt angeordnet sind, so daß die resultierenden elektrischen Ausgangssignale der mindestens zwei Hall-Elemente (3.1, 3.2, 3.3, 3.4; 13; 43; 53.1, 53.2; 63.1, 63.2, 63.3, 63.4) eine Phasenverschiebung von 90° zueinander aufweisen.

5. Magnetische Positionsmeßeinrichtung nach Anspruch 1, dadurch gekennzeichnet, daß den Hall-Elementen (3.1, 3.2, 3.3, 3.4; 13; 43; 53.1, 53.2; 63.1, 63.2, 63.3, 63.4) eine Interpolations-Einheit (59; 69) zum Erzeugen von Zählimpulsen nachgeordnet ist.

6. Magnetische Positionsmeßeinrichtung nach Anspruch 1, dadurch gekennzeichnet, daß der Synchronisationseinheit (55; 65) eine Oszillatoreinheit zugeordnet ist, welche ein periodisches Taktsignal liefert, das die Schaltfrequenz vorgibt.

7. Magnetische Positionsmeßeinrichtung nach Anspruch 1, dadurch gekennzeichnet, daß die verwendeten Hall-Elemente mitsamt der Schalt- und Synchronisationseinheit(en) in integrierter Bauweise auf einem einzigen Chip angeordnet sind.

8. Verfahren zum Betrieb einer magnetischen Positionsmeßeinrichtung zur Bestimmung der Relativlage zweier zueinander beweglicher Objekte, bei dem eine magnetische Meßteilung (10) mittels mindestens zweier Hall-Elemente (3.1, 3.2, 3.3, 3.4; 13; 43; 53.1, 53.2; 63.1, 63.2, 63.3, 63.4) zur Erzeugung mindestens zweier, phasenverschobener positionsabhängiger Ausgangssignale abgetastet wird, dadurch gekennzeichnet, daß über mindestens eine Schalteinheit (26; 46; 56.1, 56.2; 66.1, 66.2) die Versorungs- und Meßspannungen (V_{S}, U_{H}) der Hall-Elemente (3.1, 3.2, 3.3, 3.4; 13; 43; 53.1, 53.2; 63.1, 63.2, 63.3, 63.4) periodisch miteinander vertauscht werden und eine Synchronisationseinheit (55; 65) das periodische Vertauschen der Versorgungs- und Meßspannungen (V_{S}, U_{H}) an den verschiedenen Hall-Elementen (3.1, 3.2, 3.3, 3.4; 13; 43; 53.1, 53.2; 63.1, 63.2, 63.3, 63.4) miteinander synchronisiert, wozu Synchronisationssignale (sync) an die Schalteinheit (26; 46; 56.1, 56.2; 66.1, 66.2) weitergegeben werden.

9. Verfahren nach Anspruch 8, dadurch gekennzeichnet, daß die resultierenden Ausgangssignale der Hall-Elemente (3.1, 3.2, 3.3, 3.4; 13; 43; 53.1, 53.2; 63.1, 63.2, 63.3, 63.4) einer Interpolationseinheit (59, 69) zum Erzeugen von Zählimpulsen zugeführt werden.

10. Verfahren nach Anspruch 8, dadurch gekennzeichnet, daß die Versorgungs- und Meßspannungen der Hall-Elemente (3.1, 3.2, 3.3, 3.4; 13; 43; 53.1, 53.2; 63.1, 63.2, 63.3, 63.4) gleichsinnig durchgeschaltet werden.

11. Verfahren nach Anspruch 8, dadurch gekennzeichnet, daß die Versorgungs- und Meßspannungen der Hall-Elemente (3.1, 3.2, 3.3, 3.4; 13; 43; 53.1, 53.2; 63.1, 63.2, 63.3, 63.4) gegensinning durchgeschaltet werden.

## Claims

1. Magnetic position measuring device for determining the relative position of two objects which move relative to each other, comprising a magnetic measuring calibration (10) and at least two Hall elements (3.1, 3.2, 3.3, 3.4; 13; 43; 53.1, 53.2; 63.1, 63.2, 63.3, 63.4) with which the measuring calibration (10) is scanned to produce at least two phase-displaced, position-dependent output signals, the Hall elements (3.1, 3.2, 3.3, 3.4; 13; 43; 53.1, 53.2; 63.1, 63.2, 63.3, 63.4) having respectively at least one supply voltage- and at least one measuring voltage connection (1, 2, 3, 4), characterised by at least one switch unit (26; 46; 56.1, 56.2; 66.1, 66.2) which exchanges the supply voltage- and measuring voltage connections (1, 2, 3, 4) of each Hall element (3.1, 3.2, 3.3, 3.4; 13; 43; 53.1, 53.2; 63.1, 63.2, 63.3, 63.4) with each other periodically and at least one synchronisation unit (55; 65) which synchronises the periodic exchange of the supply voltage- and measuring voltage connections (1, 2, 3, 4) of the different Hall elements (3.1, 3.2, 3.3, 3.4; 13; 43; 53.1, 53.2; 63.1, 63.2, 63.3, 63.4) to each other and for this purpose transfers the synchronisation signals (sync) to the switch units (26; 46; 56.1, 56.2; 66.1; 66.2).

2. Magnetic position measuring device according to claim 1, characterised in that several Hall elements (63.1, 63.2, 63.3, 63.4) are provided, the supply voltage- and measuring voltage connections (1, 2, 3, 4) of which are respectively connected to each other in groups and a common switch unit (66.1, 66.2) is provided for each group.

3. Magnetic position measuring device according to claim 1, characterised in that the Hall elements used (3.1, 3.2, 3.3, 3.4; 13; 43; 53.1, 53.2; 63.1, 63.2, 63.3, 63.4) respectively have n supply voltage- and/or measuring voltage connections (1..4; 1..8) which are arranged cyclically about the Hall element central point (48) and arranged at angle spacings of 360°/n to each other.

4. Magnetic position measuring device according to claim 1, characterised in that a magnetic measuring calibration (10) with a fixed calibration period (T) is provided and at least two Hall elements (3.1, 3.2, 3.3, 3.4; 13; 43; 53.1, 53.2; 63.1, 63.2, 63.3, 63.4) are arranged offset from each other around the spacing of a quarter calibration period (T) of the magnetic measuring calibration (10) so that the resulting electrical output signals of at least two Hall elements (3.1, 3.2, 3.3, 3.4; 13; 43; 53.1, 53.2; 63.1, 63.2, 63.3, 63.4) have a phase displacement of 90° from each other.

5. Magnetic position measuring device according to claim 1, characterised in that an interpolation unit (59; 69) is assigned subsequently to the Hall elements (3.1, 3.2, 3.3, 3.4; 13; 43; 53.1, 53.2; 63.1, 63.2, 63.3, 63.4) to produce counting pulses.

6. Magnetic position measuring device according to claim 1, characterised in that an oscillator unit is assigned to the synchronisation unit (55; 65), which oscillator unit delivers a periodic timing signal which presets the switching frequency.

7. Magnetic position measuring device according to claim 1, characterised in that the Hall elements used together with the switch- and synchronisation unit(s) are arranged on one single chip in an integral construction.

8. Method for operating a magnetic position measuring device for determining the relative position of two objects which move relative to each other, in which method a magnetic measuring calibration (10) is scanned by means of at least two Hall elements (3.1, 3.2, 3.3, 3.4; 13; 43; 53.1, 53.2; 63.1, 63.2, 63.3, 63.4) to produce at least two, phase-displaced, position-dependent output signals, characterised in that the supply- and measuring voltages (V_{S}, U_{H}) of the Hall elements (3.1, 3.2, 3.3, 3.4; 13; 43; 53.1, 53.2; 63.1, 63.2, 63.3, 63.4) are exchanged with each other periodically via at least one switch unit (26; 46; 56.1, 56.2; 66.1, 66.2), and a synchronisation unit (55; 65) synchronises to each other the periodic exchange of the supply- and measuring voltages ( V_{S}, U_{H}) at the different Hall elements (3.1, 3.2, 3.3, 3.4; 13; 43; 53.1, 53.2; 63.1, 63.2, 63.3, 63.4) for which purpose synchronisation signals (sync) are transferred to the switch unit (26; 46; 56.1, 56.2; 66.1, 66.2).

9. Method according to claim 8, characterised in that the resulting output signals of the Hall elements (3.1, 3.2, 3.3, 3.4; 13; 43; 53.1, 53.2; 63.1, 63.2, 63.3, 63.4) are supplied to an interpolation unit (59, 69) to produce counting pulses.

10. Method according to claim 8, characterised in that the supply- and measuring voltages of the Hall elements (3.1, 3.2, 3.3, 3.4; 13; 43; 53.1, 53.2; 63.1, 63.2, 63.3, 63.4) are connected in the same direction.

11. Method according to claim 8, characterised in that the supply- and measuring voltages of the Hall elements (3.1, 3.2, 3.3, 3.4; 13; 43; 53.1, 53.2; 63.1, 63.2, 63.3, 63.4) are connected in the opposite direction.

## Revendications

1. Dispositif de mesure de position magnétique, pour déterminer la position relative de deux objets pouvant se déplacer l'un par rapport à l'autre, comprenant une division de mesure (10) magnétique et au moins deux éléments de Hall (3.1, 3.2, 3.3, 3.4; 13; 43; 53.1, 53.2; 63.1, 63.2, 63.3, 63.4) à l'aide desquels la division de mesure (10) est palpée aux fins de produire au moins deux signaux de sortie déphasés, dépendants de la position, les éléments de Hall (3.1, 3.2, 3.3, 3.4; 13; 43; 53.1, 53.2; 63.1, 63.2, 63.3, 63.4) comportant chacun au moins une borne de tension d'alimentation et une borne de tension de mesure (1, 2, 3, 4), caractérisé par
- au moins une unité de commutation (26; 46; 56.1, 56.2, 66.1, 66.2) qui permute périodiquement entre elles les bornes de tension d'alimentation et de tension de mesure (1, 2, 3, 4) de chaque élément de Hall (3.1, 3.2, 3.3, 3.4; 13; 43; 53.1, 53.2; 63.1, 63.2, 63.3, 63.4) et
- au moins une unité de synchronisation (55; 65) qui synchronise la permutation périodique des bornes de tension d'alimentation et de tension de mesure (1, 2, 3, 4) des différents éléments de Hall (3.1, 3.2, 3.3, 3.4; 13; 43; 53.1, 53.2; 63.1, 63.2, 63.3, 63.4) entre eux et transmet à cet effet des signaux de synchronisation (sync) aux unités de commutation (26; 46; 56.1, 56.2, 66.1, 66.2).

2. Dispositif de mesure de position magnétique selon la revendication 1, caractérisé par le fait qu'il est prévu plusieurs éléments de Hall (63.1, 63.2, 63.3, 63.4) dont les bornes de tension d'alimentation et de tension de mesure (1, 2, 3, 4) sont reliées entre elles par groupe et qu'une unité de commutation (66.1, 66.2) commune est prévue chaque fois pour chaque groupe.

3. Dispositif de mesure de position magnétique selon la revendication 1, caractérisé par le fait que les éléments de Hall (3.1, 3.2, 3.3, 3.4; 13; 43; 53.1, 53.2; 63.1, 63.2, 63.3, 63.4) utilisés comportent chacun n bornes de tension d'alimentation et/ou de tension de mesure (1..4; 1..8) disposées de manière cyclique autour du point médian (48) de l'élément de Hall, qui sont décalées les unes par rapport aux autres de 360°/n.

4. Dispositif de mesure de position magnétique selon la revendication 1, caractérisé par le fait qu'il est prévu une division de mesure (10) magnétique avec une période de division (T) fixe et qu'au moins deux éléments de Hall (3.1, 3.2, 3.3, 3.4; 13; 43; 53.1, 53.2; 63.1, 63.2, 63.3, 63.4) sont décalés l'un par rapport à l'autre d'une distance de un quart de la période de division (T) de la division de mesure (10) magnétique, de telle sorte que les signaux de sortie électriques résultants des éléments de Hall (3.1, 3.2, 3.3, 3.4; 13; 43; 53.1, 53.2; 63.1, 63.2, 63.3, 63.4), au nombre d'au moins deux, soient mutuellement décalés de 90°.

5. Dispositif de mesure de position magnétique selon la revendication 1, caractérisé par le fait qu'une unité d'interpolation (59; 69) est placée à a suite des éléments de Hall (3.1, 3.2, 3.3, 3.4; 13; 43; 53.1, 53.2; 63.1, 63.2, 63.3, 63.4) aux fins de produire des impulsions de comptage.

6. Dispositif de mesure de position magnétique selon la revendication 1, caractérisé par le fait qu'une unité d'oscillateur (55; 65) est associée à l'unité de synchronisation, laquelle unité d'oscillateur délivre un signal cadencé périodique qui indique la fréquence de commutation.

7. Dispositif de mesure de position magnétique selon la revendication 1, caractérisé par le fait que les éléments de Hall utilisés ainsi que l'unité (les unités) de commutation et de synchronisation sont disposées de manière intégrée sur une puce unique.

8. Procédé d'utilisation d'un dispositif de mesure de position magnétique, pour déterminer la position relative de deux objets pouvant se déplacer l'un par rapport à l'autre, selon lequel une division de mesure (10) magnétique est palpée à l'aide d'au moins deux éléments de Hall (3.1, 3.2, 3.3, 3.4; 13; 43; 53.1, 53.2; 63.1, 63.2, 63.3, 63.4) aux fins de produire au moins deux signaux de sortie déphasés, dépendants de la position, caractérisé par le fait qu'on permute à l'aide d'au moins une unité de commutation (26; 46; 56.1, 56.2, 66.1, 66.2) périodiquement entre elles les tensions d'alimentation et de mesure (V_{S}, U_{H}) des éléments de Hall (3.1, 3.2, 3.3, 3.4; 13; 43; 53.1, 53.2; 63.1, 63.2, 63.3, 63.4) et qu'une unité de synchronisation (55; 65) synchronise la permutation périodique des tensions d'alimentation et de mesure (V_{S}, U_{H}) des différents éléments de Hall (3.1, 3.2, 3.3, 3.4; 13; 43; 53.1, 53.2; 63.1, 63.2, 63.3, 63.4) entre eux, des signaux de synchronisation (sync) étant transmis à cet effet aux unités de commutation (26; 46; 56.1, 56.2, 66.1, 66.2).

9. Procédé selon la revendication 8, caractérisé par le fait que les signaux de sortie résultants des éléments de Hall (3.1, 3.2, 3.3, 3.4; 13; 43; 53.1, 53.2; 63.1, 63.2, 63.3, 63.4) sont transmis à une unité d'interpolation (59, 69) aux fins de produire des impulsions de comptage.

10. Procédé selon la revendication 8, caractérisé par le fait que les tensions d'alimentation et de mesure des éléments de Hall (3.1, 3.2, 3.3, 3.4; 13; 43; 53.1, 53.2; 63.1, 63.2, 63.3, 63.4) sont commutées dans le même sens.

11. Procédé selon la revendication 8, caractérisé par le fait que les tensions d'alimentation et de mesure des éléments de Hall (3.1, 3.2, 3.3, 3.4; 13; 43; 53.1, 53.2; 63.1, 63.2, 63.3, 63.4) sont commutées en opposition.
